# FASCICULE DE BREVET EUROPEEN

(11) **EP 0 577 531 B1**
(45) Date de publication et mention de la délivrance du brevet: **06.05.1998**
(21) Numéro de dépôt: 93420275.5
(22) Date de dépôt: 25.06.1993
(51) Int. Cl.: H01L 29/866, H01L 23/62

(54) **Diode de protection pour composant semiconducteur vertical**
Schutzdiode für ein vertikales Halbleiterbauelement
Protection diode for a vertical semiconductor device

(30) Priorité: 30.06.1992 FR 9208483
(43) Date de publication de la demande: 05.01.1994
(73) Titulaire: SGS-THOMSON MICROELECTRONICS S.A., 94250 Gentilly (FR)
(72) Inventeur: Mille, Jacques, F-13100 Aix-en-Provence (FR); Meunier, Philippe, F-13100 Aix-en-Provence (FR)
(74) Mandataire: de Beaumont, Michel

(56) Documents cités:
- EP-A- 0 236 200
- US-A- 4 051 504
- US-A- 4 792 840
- US-A- 5 053 743

## Description

La présente invention concerne les transistors de puissance verticaux haute tension qui sont des dispositifs réalisés verticalement sur une tranche de silicium (habituellement constituée d'une couche épitaxiée N sur un substrat N⁺) dont la face arrière est connectée à une haute tension. L'invention s'applique à des transistors de puissance verticaux de type MOS, bipolaires ou à grille isolée. Elle s'applique notamment au cas des commutateurs de puissance "intelligents" (Smart Power Switch) qui sont des circuits comprenant sur une même puce de silicium des composants de puissance verticaux et des circuits logiques de commande de ces composants.

Les transistors de puissance sont conçus pour supporter une tension directe définie (par exemple 400 volts). Si le circuit externe applique une tension plus importante au dispositif, celui-ci entre dans un mode de claquage susceptible de l'endommager. Par exemple, la commutation d'une charge inductive produit une surtension avec une certaine quantité d'énergie à dissiper. Cette surtension est appliquée sur le commutateur de puissance qui est à l'état bloqué. L'une des solutions pour protéger le dispositif est de l'amener brièvement dans un état conducteur pendant la durée nécessaire pour écouler l'énergie excessive à travers le dispositif.

On cherche donc à prévoir un dispositif tel qu'une diode à avalanche qui entre en conduction pour une valeur un peu inférieure à la tension de claquage du ou des transistors de puissance pour, par exemple, déclencher la mise en conduction de ces transistors avant leur seuil de claquage et éviter ainsi tout endommagement.

Un objet de la présente invention est de prévoir une diode à avalanche de seuil de déclenchement élevé déterminé qui puisse être intégrée sur une même puce que les transistors de puissance sans modifier, ou en modifiant aussi peu que possible, le procédé de fabrication du circuit intégré comprenant des transistors de puissance et éventuellement leur circuit logique de commande. Le signal de conduction de la diode pourra alors être envoyé à la base ou à la grille du transistor de puissance pour le remettre en conduction pendant une durée choisie ou pendant la durée de la surtension.

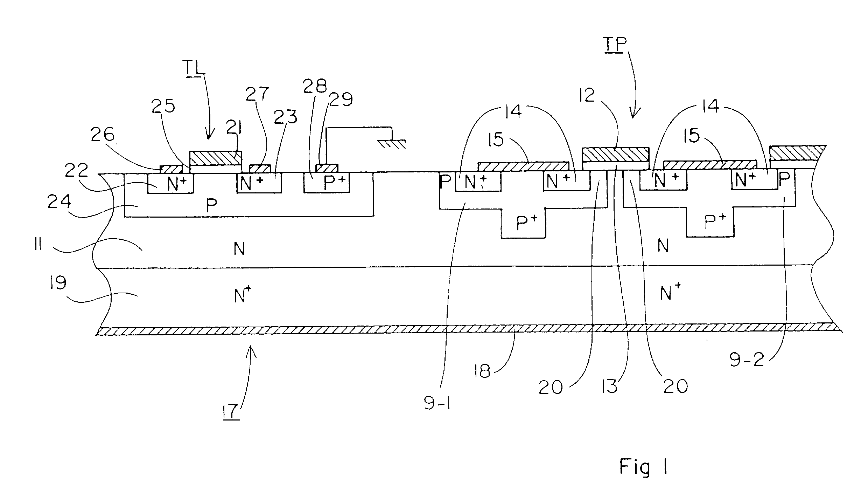

Pour mieux faire comprendre le problème que vise à résoudre la présente invention, la figure 1 représente en coupe un exemple de structure mixte classique comprenant un transistor MOS de puissance vertical TP de type diffusé (VDMOS), dont une cellule est représentée, ce transistor étant associé à des circuits logiques dont un transistor MOS à canal N TL est illustré.

La structure est réalisée dans un substrat 11 d'un premier type de conductivité, par exemple de type N. Une cellule du transistor MOS de puissance TP comprend une région 9-1, 9-2, constituée par des diffusions d'un deuxième type de conductivité, par exemple de type P. Dans chaque région 9-1, 9-2 sont réalisées deux diffusions 14 de type N⁺ qui constituent la source du transistor de puissance. Les deux diffusions 14 sont connectées entre elles par une couche conductrice 15 qui est par exemple réalisée en aluminium. Les bords latéraux des régions 9-1, 9-2 constituent une région de canal 20 du transistor de puissance.

Chaque cellule du transistor MOS de puissance TP comprend une grille 12 formée par une couche de silicium polycristallin. Cette grille 12 est séparée du substrat 11 par une couche d'oxyde 13.

La face arrière 17 du substrat 11 comprend une couche surdopée 19 revêtue d'une métallisation de drain 18.

Le transistor MOS TL de la partie logique est formé dans un caisson 24 de type P. Ce caisson 24 comporte deux diffusions de type N⁺, la première diffusion constituant la source 22 et la seconde diffusion constituant le drain 23 du transistor TL. Ce transistor comprend une grille 21 constituée par une couche de silicium polycristallin. La grille 21 est séparée du caisson 24 par une couche d'oxyde 25. Les diffusions constituant la source 22 et le drain 23 sont chacune connectée à une ligne conductrice désignée par 26, 27, respectivement. Les lignes conductrices 26, 27 sont par exemple en aluminium.

De façon classique, on prévoit dans le caisson 24 une zone 28 de type P⁺ connectée à une couche conductrice 29. La zone 28 et la couche conductrice 29 permettent la mise à la masse du caisson 24.

En fonctionnement normal, la métallisation de face arrière 18 est connectée à un potentiel positif et les métallisations de face avant 15 du transistor de puissance sont connectées à un potentiel négatif par rapport à ce potentiel positif, par exemple un potentiel voisin du potentiel de la masse.

Le problème que l'on veut résoudre est d'éviter la mise en conduction par claquage du transistor de puissance, c'est-à-dire de la jonction entre le substrat 11 et les caissons P 9-1 et 9-2 quand la tension de drain croît alors que le transistor est à l'état bloqué. On notera qu'il y a aussi, dans le cas représenté d'un circuit intégré comprenant une partie logique, le risque d'un claquage de la jonction entre le substrat et les caissons dans lesquels sont disposés les composants logiques.

Pour réaliser une diode claquant avant la jonction entre le substrat 11 et les caissons, on pourrait envisager de réaliser cette diode sous forme verticale en prévoyant dans le substrat N une région de type P de niveau de dopage choisi pour claquer avant la jonction avec les caissons des transistors de puissance et de la partie logique. Néanmoins, ceci nécessiterait la prévision d'une étape technologique supplémentaire pour réaliser cette région de type P spécifiquement dopée. Malgré la complexité de ce procédé, c'est vers cette réalisation que sont orientées les études de l'art antérieur. En effet, la réalisation d'une diode sur la face avant du substrat se heurte à un obstacle qui est que cela nécessite d'amener la haute tension disponible sur la métallisation de face arrière vers la face avant. Ceci perturbe la répartition des lignes de champ dans le composant qui est soigneusement ajustée pour obtenir justement la tenue en tension maximale souhaitée (par exemple 400 volts comme indiqué précédemment).

On notera par ailleurs qu'il est connu, par exemple des brevets US-A-4 792 840 et 5 053 743 de réaliser sur la face avant du substrat une résistance dont une borne est connectée à la face arrière, cette résistance ayant la forme d'une spirale. Néanmoins, aucun de ces deux brevets ne suggère que cette technologie pourrait être étendue à l'obtention de diodes.

Pour atteindre ses objets, la présente invention prévoit une diode à avalanche haute tension formée dans un circuit intégré comprenant au moins un composant de puissance vertical. Le circuit intégré est réalisé dans un substrat semiconducteur d'un premier type de conductivité dont la face arrière correspond à une première électrode principale du ou des composants de puissance. Les deuxièmes électrodes principales du ou des composants de puissance correspondent à une ou plusieurs régions formées dans au moins une région du deuxième type de conductivité formée dans la face avant du substrat.

Cette diode comprend une région du deuxième type de conductivité enroulée sensiblement en spirale, formée dans la face avant du substrat ; des régions disjointes du premier type de conductivité formées dans la spirale en nombre égal par tour, constituant avec celle-ci des diodes à avalanche élémentaires ; des métallisations connectant en série les diodes élémentaires ; et une connexion entre une extrémité de la spirale et la première électrode.

Selon un mode de réalisation de la présente invention, le circuit intégré comprend en outre des composants logiques formés dans des caissons du deuxième type de conductivité formés à partir de la face avant du substrat.

Selon un mode de réalisation de la présente invention, la connexion susmentionnée est constituée d'une métallisation reliant une extrémité de la spirale à une région surdopée du premier type de conductivité de la face avant du substrat.

Selon un mode de réalisation de la présente invention, la connexion susmentionnée est réalisée dans la région centrale de la spirale.

Selon un mode de réalisation de la présente invention, la spirale est interrompue au voisinage de chaque zone où y est formée une région du premier type de conductivité.

Selon un mode de réalisation de la présente invention, les métallisations connectant en série les diodes élémentaires recouvrent des portions de la spirale comprises entre deux diodes et s'étendent vers l'extérieur ou vers l'intérieur à partir de ces portions en direction du tour suivant de la spirale à potentiel plus faible.

En d'autres termes, la présente invention concerne une diode à avalanche formée dans une structure semiconductrice associant au moins un transistor de puissance et une partie logique ou analogique sur un même substrat semiconducteur, le transistor de puissance étant du type vertical et comprenant une électrode principale sur la face arrière du substrat. Cette diode comprend une région du deuxième type de conductivité enroulée sensiblement en spirale, formée dans la face avant du substrat ; des régions disjointes du premier type de conductivité formées dans la spirale en nombre égal par tour et constituant avec celle-ci des diodes à avalanche élémentaires ; des métallisations connectant en série les diodes élémentaires ; et une connexion entre une extrémité de la spirale et la première électrode.

Ainsi, la présente invention utilise des diodes à avalanche de type latéral, disposées sur la face avant, en série. Dans un dispositif de puissance, il est possible d'intégrer des diodes latérales basse tension (5 à 20 volts). A titre d'exemple, la jonction base-émetteur d'un transistor bipolaire de puissance ou la jonction source-caisson d'une cellule MOS peut être utilisée. Chaque diode peut être très petite et, en en connectant plusieurs en série, on obtient avec précision la tension de détection désirée. Par exemple, si l'on veut atteindre une tension de protection de 380 volts, 38 diodes ayant une tension de claquage de 10 volts seront disposées en série.

Ces objets, caractéristiques et avantages ainsi que d'autres de la présente invention seront exposés en détail dans la descriptior suivante de modes de réalisation particuliers faite en relation avec les figures jointes parmi lesquelles :
la figure 1 représente à titre d'exemple une vue en coupe d'un circuit intégré comprenant un transistor MOS vertical et une partie logique ;
la figure 2 représente une vue de dessus d'une diode à avalanche haute tension selon la présente invention ;
la figure 3A représente une vue de dessus agrandie correspondant à la vue en coupe partielle de la figure 3B ;
la figure 3B représente une vue en coupe selon la ligne 3B-3B de la figure 2 ;
la figure 4 représente une vue en coupe selon la ligne 4-4 de la figure 2 ;
la figure 5 représente une vue en coupe selon la ligne 5-5 de la figure 2 ; et
la figure 6 représente une vue de dessus d'une diode selon la présente invention munie de ses métallisations.

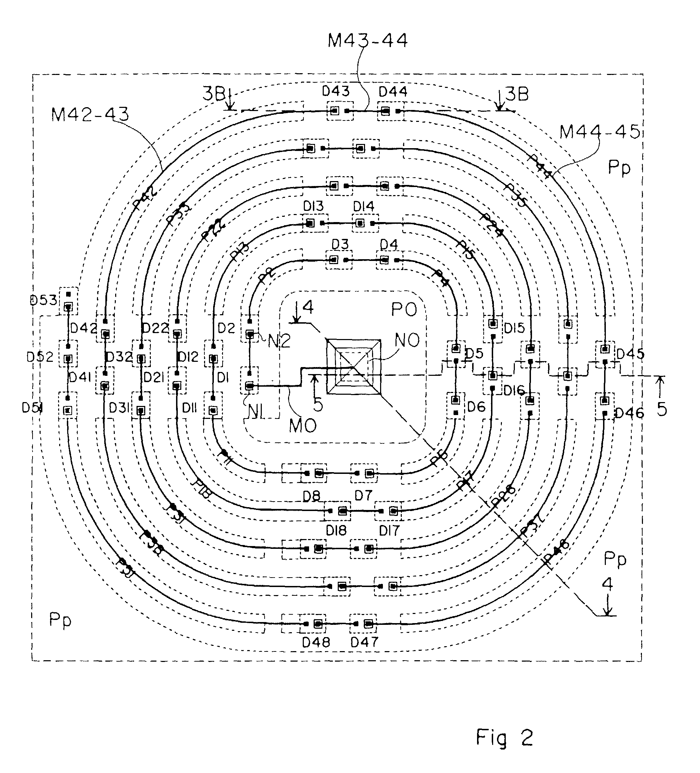

La figure 2 représente un exemple de réalisation d'une diode à avalanche de type spiral selon la présente invention. Bien que cela ne soit pas décrit, il est clair que cette vue de dessus constitue seulement une partie d'une puce de circuit intégré dont les autres parties correspondent par exemple à ce qui est illustré en figure 1.

La figure 2 représente une vue de dessus d'une diode à avalanche selon la présente invention à une étape intermédiaire de fabrication où les métallisations n'ont pas encore été formées. Cette figure représente un caisson P comprenant une partie centrale P0 et une partie spirale s'étendant vers une région périphérique Pp. Dans le mode de réalisation représenté, chaque tour de cette spirale comprend des parties horizontales et verticales sensiblement rectilignes et est interrompu au niveau de ces parties rectilignes. La région centrale de la partie P0 comprend une région diffusée de type N N0 qui rejoint le substrat et qui est donc au potentiel de la métallisation de face arrière. La région périphérique Pp est normalement connectée au potentiel de réference bas.

Le long de chaque tour de la spirale sont disposées des régions N dans cette spirale pour former des diodes successives. Dans le mode de réalisation représenté, la spirale comprend un petit peu plus de cinq tours, le premier tour comprenant des diodes D1 à D8, le deuxième tour des diodes D11 à D18, le troisième tour des diodes D21 à D28, le quatrième tour des diodes D31 à D38, le cinquième tour des diodes D41 à D48 et la portion de dernier tour des diodes D51, D52 et D53. Chaque diode est reliée à la suivante par une métallisation M représentée schématiquement par un trait en figure 2.

Ainsi, les tours successifs de la spirale sont à des potentiels progressivement décroissants, ce qui permet, comme cela a été exposé dans le cas des résistances spirales faisant l'objet des brevets américains précédemment cités, d'étaler la répartition des lignes de champ. On évite ainsi des transitions brusques de potentiel entre des points voisins de la surface du composant et donc une réduction indésirée de sa tenue en tension.

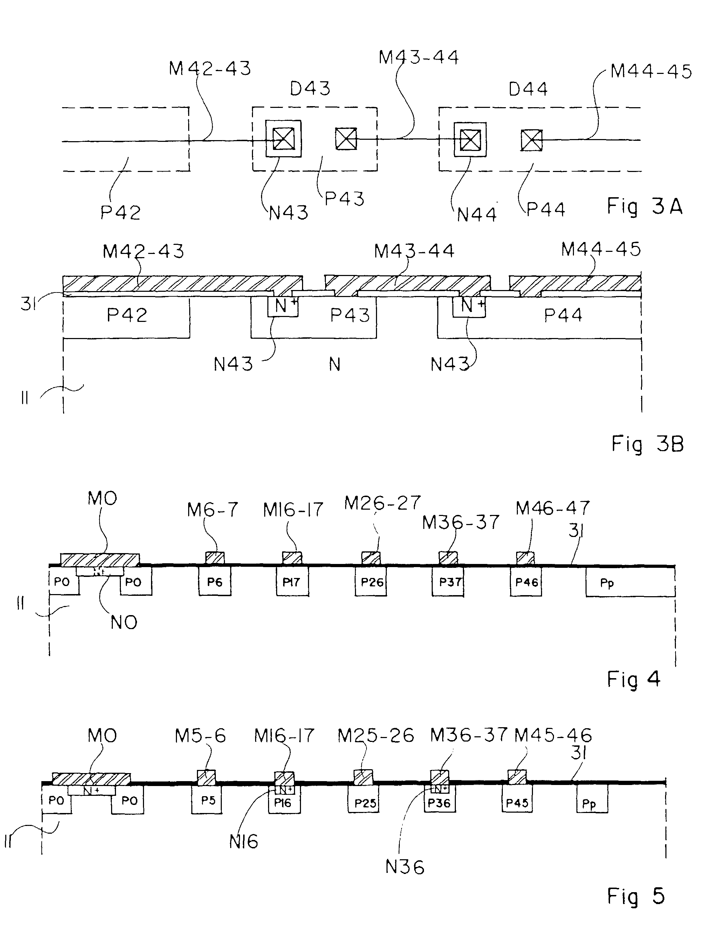

La structure selon l'invention sera mieux comprise en examinant les figures 3, 4 et 5.

La figure 3 comprend des figures 3A et 3B. La figure 3B représente une vue en coupe partielle selon la ligne 3B-3B de la figure 2 et la figure 3A représente une vue de dessus correspondante. On peut voir dans cette figure les diodes D43 et D44. La diode D43 est formée dans une portion P43 du caisson spiral de type P et comprend une région N N43. La surface de la structure est revêtue d'une couche isolante 31, classiquement une couche d'oxyde, sauf en des emplacements où des contacts marqués d'une croix en figure 3A sont ménagés. Ainsi, un contact est assuré sur la région N43 et un contact sur la région P43. Le contact sur la région N43 est relié par une métallisation M42-43, représentée de façon symbolique par un trait en figure 3A, au contact sur la région P42 de la diode D42 précédente. Le contact sur la région P43 est relié par une métallisation M43-44 au contact sur la région N44 de la diode D44 suivante. Le caisson spiral est formé dans un substrat qui correspond, par exemple, à une partie du substrat 11 illustré en figure 2.

La figure 4 représente une vue en coupe schématique selon la ligne 4-4 de la figure 1. On peut voir à la partie gauche de la figure la coupe de la partie centrale comprenant la région N0 en contact avec le substrat 11 et entourée de la région P0. Ces régions N0 et P0 sont contactées par une métallisation M0 qui rejoint, comme cela est représenté symboliquement en figure 2, le contact sur la région N1 de la diode D1. On voit aussi en coupe des régions successives P6, P17, P26, P37, P46 et Pp, toutes revêtues d'une région isolante puisque l'on est en dehors des zones de contact. La région P6 est revêtue de la métallisation M6-7, la région P17 de la métallisation M16-17, la région P26 de la métallisation M26-27, la région P37 de la métallisation M36-37 et la région P46 de la métallisation M46-M47.

La figure 5 représente une vue en coupe selon la ligne de coupe brisée 5-5 de la figure 2. Cette vue en coupe a été brisée pour passer par des régions de contacts entre une métallisation et la couche sous-jacente. La partie gauche de la figure est similaire à la partie gauche de la figure 4. Ensuite, on trouve les régions de type P P5, P16, P25, P36, P45 puis Pp. Dans les régions P16 et P36 sont formées des régions N, respectivement N16 et M36. Un contact avec les régions P5, N16, P25, M36 et P45 est établi par des métallisations respectives M5-6, M16-17, M25-26, M36-37, M45-46.

A la lumière de cette description des figures 3 à 5, on comprend mieux la vue de dessus de la figure 2 dans laquelle de mêmes références sont utilisées qu'en figures 3 à 5.

Dans la figure 2, les régions P de la spirale sont interrompues en divers emplacements, au voisinage des zones où y sont formées des régions N pour mieux séparer entre elles les diverses diodes élémentaires. Toutefois, cette spirale de type P pourrait être continue. Ceci aurait pour résultat que chacune des diodes serait en parallèle avec une résistanoe de valeur élevée. En effet, la région P est de dopage relativement faible et sa résistance par carré n'est pas négligeable. Ainsi, les diodes série selon la présente invention présenteraient une certaine résistance parallèle d'où il résulterait une certaine fuite mais ceci ne nuirait pas au fonctionnement fondamental du circuit.

On notera aussi en considérant la figure 2 que les emplacements où la spirale P est interrompue sont choisis pour ne pas être toutes alignés selon un axe radial. C'est ce qui explique le décalage apparaissant entre les diodes successives, par exemple dans la région où on a tracé la ligne de coupe 5-5. Ceci a pour but d'assurer une meilleure répartition des potentiels et d'éviter les phénomènes liés à une courbure excessive des lignes de champ quand un potentiel élevé est appliqué entre les faces avant et arrière. Bien que cela ne soit pas représenté sur la figure, la dernière diode D53 aura sa région de contact P reliée au potentiel bas de la structure, par exemple à la borne de grille ou de base du transistor de puissance que cette diode vise à protéger contre des surtensions directes.

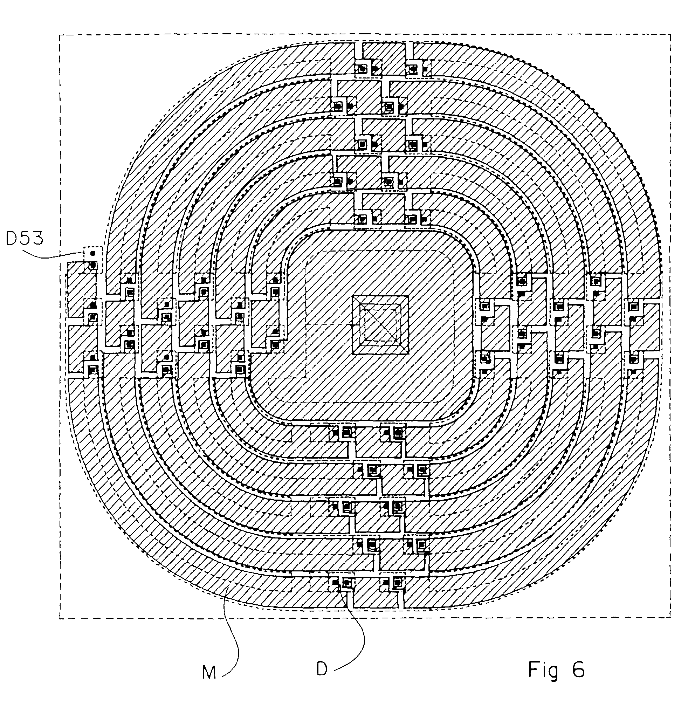

La figure 6 est une vue de dessus qui correspond à celle de la figure 2 mais dans laquelle les diverses métallisations ont été indiquées. On notera que chaque métallisation reliant deux diodes successives de la spirale déborde vers l'extérieur par rapport à chaque région P qu'elle recouvre pour avoir la fonction dite de plaque de champ (en anglais : field plate) et améliorer encore la répartition des potentiels. Bien que cela ne soit pas représenté dans la figure, le dernier contact de la diode D53 est connecté par une métallisation de la façon indiquée précédemment. Cette figure se comprend bien à partir de l'analyse des figures précédentes, aussi elle ne porte pas de référence sauf les références générales M pour désigner une métallisation et D pour désigner une diode ainsi que la référence D53 pour désigner la dernière diode de la spirale.

La diode selon l'invention n'est pas nécessairement utilisée avec une structure du type de celle illustrée en figure 1 mais peut être utilisée avec d'autres structures de composants de puissance verticaux.

Des moyens autres qu'un contact central N⁺ peuvent être utilisés pour assurer la conduction entre la face arrière et la face avant du substrat. On pourra prévoir une connexion spéciale arrivant au centre de la spirale.

Les contacts sur différents points de la spirale de type P pour former une électrode des diverses diodes seront de préférence formés sur une région surdopée de cette spirale pour améliorer l'ohmicité des contacts.

Par ailleurs, on a représenté et décrit en relation avec les diverses figures une spirale fermée autour d'un centre sur lequel arrive la haute tension. On pourrait également envisager que la spirale selon la présente invention entoure l'ensemble de la puce de circuit intégré, des composants tels que les transistors de puissance verticaux et les divers composants logiques étant formés dans la partie centrale du circuit intégré. En ce cas, c'est la partie extérieure de la spirale qui sera amenée au potentiel de la métallisation de face arrière.

Bien que des modes de réalisations particuliers de la présente invention aient été décrits en relation avec des transistors MOS verticaux correspondant à une technologie de fabrication particulière, elle s'applique de façon générale à de nombreuses autres technologies comprenant un composant de puissance vertical. Le composant de puissance vertical peut être de type bipolaire. Ce composant de puissance peut être associé à des circuits logiques formés autrement que dans des caissons de type P, par exemple sur isolant ou en association avec des couches enterrées.

## Revendications

1. Diode à avalanche haute tension de protection formée dans un circuit intégré comprenant au moins un composant de puissance vertical, ce circuit intégré étant réalisé dans un substrat semiconducteur d'un premier type de conductivité (11) dont la face arrière correspond à une première électrode principale du composant de puissance dont la deuxième électrode principale correspond à au moins une région formée dans au moins une région du deuxième type de conductivité elle-même formée dans la face avant du substrat, ladite diode étant caractérisée en ce qu'elle comprend :
une région du deuxième type de conductivité (P0,P1... P53,Pp) enroulée sensiblement en spirale, formée dans la face avant du substrat ;
des régions disjointes du premier type de conductivité (N1...N53) formées dans la spirale en nombre égal par tour et constituant avec celle-ci des diodes à avalanche élémentaires ;
des métallisations (M1-2... M52-53) connectant en série lesdites diodes élémentaires ; et
une connexion (M0,N0) entre une extrémité de ladite spirale et ladite première électrode.

2. Diode à avalanche haute tension selon la revendication 1, caractérisée en ce que le circuit intégré comprend en outre des composants logiques dans des caissons du deuxième type de conductivité formés à partir de la face avant du substrat.

3. Diode selon la revendication 1 ou 2, caractérisé en ce que ladite connexion est constituée d'une métallisation (M0) reliant une extrémité de la spirale à une région surdopée (N0) du premier type de conductivité de la face avant du substrat.

4. Diode selon la revendication selon l'une quelconque des revendications 1 à 3, caractérisée en ce que ladite connexion est réalisée dans la région centrale de la spirale.

5. Diode selon l'une quelconque des revendications 1 à 4, caractérisée en ce que ladite spirale est interrompue au voisinage de chaque zone où y est formée une région du premier type de conductivité.

6. Diode à avalanche selon la revendication 1, caractérisée en ce que lesdites métallisations connectant en série les diodes élémentaires recouvrent des portions de la spirale comprises entre deux diodes et s'étendent vers l'extérieur ou vers l'intérieur à partir de ces portions en direction du tour suivant de la spirale à potentiel plus faible.

7. Diode à avalanche selon la revendication 1, caractérisée en ce que le composant de puissance est un transistor de puissance du type vertical qui est associé à une partie logique ou analogique sur le même substrat semiconducteur,

## Patentansprüche

1. In einer wenigstens ein vertikales Leistungsbauteil enthaltenden integrierten Schaltung ausgebildete Hochspannungsschutz-Lawinendiode, wobei die integrierte Schaltung in einem Halbleitersubstrat (11) eines ersten Leitfähigkeitstyps ausgebildet ist, dessen Rückseite einer ersten Hauptelektrode des Leistungsbauteils entspricht, dessen zweite Hauptelektrode wenigstens einem Bereich entspricht, der in wenigstens einem Bereich vom zweiten Leitfähigkeitstyps ausgebildet ist, der seinerseits in der Vorderseite des Substrats ausgebildet ist, wobei die genannte Diode dadurch gekennzeichnet ist, daß sie umfaßt:
- einen in der Vorderseite des Substrats ausgebildeten, im wesentlichen spiralförmig gewickelten Bereich vom zweiten Leitfähigkeitstyp (P0, P1 ... P53, Pp);
- gesonderte, unverbundene Bereiche des ersten Leitfähigkeitstyps (N1 ... N53), die in der Spirale in gleicher Zahl je Wicklung ausgebildet sind und mit dieser elementare Lawinendioden bilden;
- Metallisierungen (M1-2 ... M52-53), welche die genannten Elementardioden in Reihe miteinander verbinden; sowie
- eine Verbindung (M0, NO) zwischen einem Ende der genannten Spirale und der genannten ersten Elektrode.

2. Hochspannungs-Lawinendiode nach Anspruch 1,
dadurch gekennzeichnet, daß die integrierte Schaltung des weiteren Logikschaltbauteile in von der Vorderseite des Substrats ausgebildeten Gräben vom zweiten Leitfähigkeitstyp aufweist.

3. Diode nach Anspruch 1 oder 2,
dadurch gekennzeichnet, daß die genannte Verbindung aus einer Metallisierung (M0) besteht, welche ein Ende der Spirale mit einem stark dotierten Bereich (N0) vom ersten Leitfähigkeitstyp in der Vorderseite des Substrats verbindet.

4. Diode nach einem der Ansprüche 1 bis 3,
dadurch gekennzeichnet, daß die genannte Verbindung im Mittelbereich der Spirale ausgebildet ist.

5. Diode nach einem der Ansprüche 1 bis 4,
dadurch gekennzeichnet, daß die genannte Spirale jeweils benachbart jeder Zone, wo ein Bereich des ersten Leitfähigkeitstyps ausgebildet ist, unterbrochen ist.

6. Lawinendiode nach Anspruch 1,
dadurch gekennzeichnet, daß die genannten Metallisierungen, welche die Elementardioden in Reihe verbinden, zwischen zwei Dioden liegende Teile der Spirale bedecken und sich, ausgehend von diesen Bereichen, auswärts oder einwärts in Richtung auf die nächste Windung der Spirale mit niedrigerem Potential erstrecken.

7. Lawinendiode nach Anspruch 1,
dadurch gekennzeichnet, daß das Leistungsbauteil ein Leistungstransistor vom Vertikaltyp ist, der einem Digitaloder Analogteil auf demselben Halbleitersubstrat zugeordnet ist.

## Claims

1. A high voltage protection avalanche diode formed in an integrated circuit including at least one vertical power component, said integrated circuit being made in a semiconductor substrate of a first conductivity type (11), the rear surface of which corresponds to a first main electrode of the power component, whose second main electrode corresponds at least to one region formed in at least one region of the second conductivity type, in turn formed in the front surface of said substrate, characterized in that it includes:
a region of the second conductivity type (P0, P1...P53, Pp) wound substantially as a spiral, formed in the front surface of said substrate;
non-overlapping regions of the first conductivity type (N1...N53) formed in said spiral in equal number per turn and forming elemental avalanche diodes with said spiral;
metallizations (M1-2... M52-53) connecting in series said elemental diodes; and
a connection (M0, N0) between an extremity of said spiral and said first electrode.

2. The high voltage avalanche diode of claim 1, characterized in that the integrated circuit further includes wells of the second conductivity type formed from the front surface of the substrate and logic circuits formed in said wells.

3. The diode of claim 1 or 2, characterized in that said connection is formed by a metallization (M0) connecting an extremity of the spiral to an overdoped region (N0) of the first conductivity type of the front surface of the substrate.

4. The diode of any of claims 1 to 3, characterized in that said connection is made in the central region of the spiral.

5. The diode of any of claims 1 to 4, wherein said spiral is interrupted near each area where is formed a region of the first conductivity type.

6. The diode of claim 1, wherein said metallizations that connect in series the elemental diodes overly the portions of the spiral comprised between two diodes and extend outwardly or inwardly from said portion toward the next spiral turn having a lower voltage.

7. An avalanche diode of claim 1, characterized in that the power component is a vertical-type power transistor associated with a logic or analog portion on the same semiconductor substrate.
